# EUROPEAN PATENT APPLICATION

(11) **EP 2 763 169 A1**
(43) Date of publication of application: **06.08.2014**
(21) Application number: 14166650.3
(22) Date of filing: 29.08.2012
(51) Int. Cl.: H01L 23/552

(54) **Chip packaging structure and method for electromagnetic shielding**

(30) Priority: 02.09.2011 CN 201110258811
(62) Divisional of application: 12799503.3
(71) Applicant: Huawei Device Co., Ltd., Longgang District Shenzhen Guangdong 518129 (CN)
(72) Inventor: Zhao, Long, 518129 Shenzhen (CN); Li, Chunshu, 518129 Shenzhen (CN)
(74) Representative: Epping - Hermann - Fischer

(57) **Abstract**

The present invention relates to the field of chip packaging and discloses a chip packaging structure, a chip packaging method, and an electronic device, which are used to solve a problem that in the chip packaging structure, a shielding film formed by a conductive coating easily drops off. The chip packaging structure includes: a printed circuit board PCB (11); a shielding can, where the shielding can (12) is fixedly set on a component side of the PCB; and a chip (13) to be shielded, where the chip to be shielded is set on the component side of the PCB and is located inside the shielding can, and pins of the chip to be shielded are connected to a first pad (16) on the PCB and the chip to be shielded does not touch the shielding can. The solution provided in the present invention can be applied to chip packaging.

## Description

### FIELD OF THE INVENTION

The present invention relates to the field of chip packaging, and in particular, to a chip packaging structure, a chip packaging method, and an electronic device.

### BACKGROUND OF THE INVENTION

In high-density packaging technologies, a chip may undergo interference from an external electromagnetic signal, which causes decline of performance and even damage of the chip, and additionally causes a fault of a device where the chip is located.

Currently, a chip packaging structure with a shielding function emerges, and this chip packaging structure usually adopts a manner of spraying a conductive coating on a plastic packaged chip surface so as to shield interference of the external electromagnetic signal. And another chip packagingstructure with conformal shield emerges, this structure comprises: a conformal shield fixed on a component side of a PCB, and a chip to be shielded by the conformal shield. However, in this chip packaging structure, a shielding film formed by the conductive coating drops off easily, thereby an anti-interference capability of the chip packaging structure is caused to decrease and leading to an unsatisfactory shielding function of the chip packaging structure.

### SUMMARY OF THE INVENTION

Embodiments of the present invention provide a chip packaging structure, a chip packaging method, and an electronic device, which are used to solve a problem that in the chip packaging structure, a shielding film formed by a conductive coating easily drops off. To solve the foregoing problem, embodiments of the present invention adopt the following technical solutions:

In one aspect, a chip packaging structure is provided, including:
a printed circuit board PCB;
a shielding can, where the shielding can is fixedly set on a component side of the PCB, the shielding can comprises a metal plate and a conductor that touches and supports the metal plate; the conductor of the shielding can is welded onto a second pad on the component side of the PCB;and
a chip to be shielded, where the chip to be shielded is set on the component side of the PCB and is located inside the shielding can, and pins of the chip to be shielded are connected to a first pad on the PCB; and
the chip to be shielded does not touch the shielding can;
wherein,
the shape of pad including: circular, square, oval, rectangular, or octagonal; and,
the shape of the first pad is decided by the shapes of pins, the shape of the second pad is decided by the shape of the conductor.

In another aspect, a chip packaging method is provided, including:
designing a first pad and a second pad on a printed circuit board PCB;
on a component side of the PCB, adopting a chip bonding process to connect pins of a chip to be shielded and the first pad; and
setting a shielding can comprising a metal plate and a conductor that touches and supports the metal plate on the component side of the PCB, fixedly connecting the shielding can and the second pad, comprising welding the conductor of the shielding can onto the second pad on the component side of the PCB, and wherein the shielding can is not touching the chip to be shielded;
wherein,
the shape of pad including: circular, square, oval, rectangular, or octagonal; and,
the shape of the first pad is decided by the shapes of pins, the shape of the second pad is decided by the shape of the conductor.

In another aspect, an electronic device is provided, including the foregoing chip packaging structure.

The chip packaging structure, the chip packaging method, and the electronic device are provided in embodiments of the present invention, where the chip packaging structure includes: the PCB, the shielding can which is fixedly set on the component side of the PCB, and the chip to be shielded; where the chip to be shielded is set on the component side of the PCB and is located inside the shielding can, and the pins of the chip to be shielded are connected to the first pad on the PCB. In this way, the pins of the chip to be shielded can be led out through the first pad of the PCB. Meanwhile, the chip to be shielded does not touch the shielding can, so that the shielding can does not interfere with the working of the chip to be shielded. Compared with the prior art, in the chip packaging structure provided in embodiments of the present invention, the changeable shape of the pad that is decided by the shapes of pins and the shape of the conductor can make a more fixed connection between the shielding can and the PCB, the shielding can in this chip packaging structure does not drop off easily, thereby enhancing an anti-interference capability of the chip packaging structure.

### BRIEF DESCRIPTION OF THE DRAWINGS

To illustrate the technical solutions in the embodiments of the present invention or in the prior art more clearly, the accompanying drawings required for describing the embodiments or the prior art are introduced briefly in the following. Apparently, the accompanying drawings in the following descriptions are merely some embodiments of the present invention, and persons of ordinary skill in the art can further obtain other drawings according to the accompanying drawings without creative efforts.
FIG. 1 is a section diagram of a chip packaging structure according to an embodiment of the present invention;
FIG. 2 is a vertical view of a chip packaging structure according to an embodiment of the present invention;
FIG. 3 is a flow chart of a chip packaging method according to an embodiment of the present invention; and
FIG. 4 is a flow chart of another chip packaging method according to an embodiment of the present invention.

Markings in the accompanying drawings:
100-chip packaging structure; 11-PCB, 12-shielding can, 121-conductor, 122-metal plate, 13-chip to be shielded, 14-insulating material, 15-second pad, 16-first pad, and 17-conducting wire.

### DETAILED DESCRIPTION OF THE EMBODIMENTS

The technical solutions of the embodiments of the present invention are described clearly and completely with reference to the accompanying drawings in the embodiments of the present invention in the following. Apparently, the described embodiments are only some embodiments of the present invention, rather than all embodiments of the present invention. All other embodiments obtained by persons of ordinary skill in the art based on the embodiments of the present invention without creative efforts shall fall within the protection scope of the present invention.

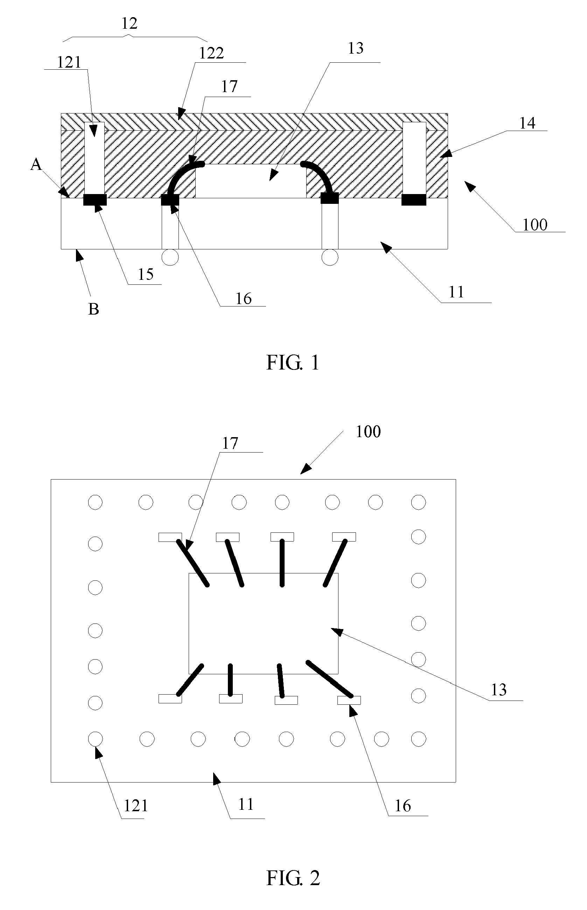

A chip packaging structure 100 provided in an embodiment of the present invention is shown as FIG. 1 and includes a PCB (Printed Circuit Board, printed circuit board) 11, a shielding can 12, and a chip 13 to be shielded. The shielding can 12 is fixedly set on a component side of the PCB 11, that is, on side A in FIG. 1; the chip 13 to be shielded is set on the component side of the PCB 11 and is located inside the shielding can 12; pins of the chip 13 to be shielded are connected to a first pad 16 on the PCB 11; and the chip 13 to be shielded does not touch the shielding can 12.

The chip to be shielded in this embodiment may be a bare chip, a packaged chip, a chip sprayed with a conductive coating, or a chipset, which needs to be isolated from an external electromagnetic wave.

The shielding can may be any can which is capable of shielding the external electromagnetic wave and capable of isolating the chip to be shielded which is located inside the shielding can from the external electromagnetic wave. Meanwhile, the shielding can is fixedly set on the component side of the PCB, and the fixing manner may be any manner of fixing the shielding can on the PCB. In this way, the shielding can in the chip packaging structure does not drop off easily, thereby enhancing an anti-interference capability of the chip packaging structure.

In particular, in one aspect, the first pad may be fixedly connected to the pins of the chip to be shielded, and in another aspect, it may further lead the pins of the chip to be shielded of the component side of the PCB out to a non-component side.

Further, the shielding can 12 includes a metal plate 122 and a conductor 121 that touches and supports the metal plate 122. In this case, the fixedly setting the shielding can 12 on the component side of the PCB 11 may specifically be: welding the conductor 121 of the shielding can 12 onto a second pad 15 on the component side of the PCB 11. In this embodiment, the metal plate of the shielding can not only has an effect of preventing the chip to be shielded from external electromagnetic interference, but also has a good effect of heat dissipation; compared with the prior art, it does not need to depend on the PCB for heat dissipation, thereby avoiding generating an influence on another circuit on the PCB.

It should be noted that the pad may be of multiple shapes, and may be circular, square, oval, rectangular, and octagonal. Its specific shape is decided by the shape of a component that it bears. In this embodiment, the shape of the first pad is decided by the shapes of pins, and the shape of the second pad is decided by the shape of the conductor.

Preferentially, the conductor 121 is a conductor with an exposed surface, and may specifically be a metal wire or a solder ball. Further preferentially, the conductor is grounded. A manner for grounding the conductor may be connecting the conductor to grounding pins of the chip to be shielded, and may also be leading out, by the second pad, the conductor to be grounded. Definitely, another manner is not excluded to ground the conductor, so that the shielding can is able to better shield interference of an external electromagnetic signal.

Further, insulating material 14 is filled in between the shielding can 12 and the PCB 11 which is set with the chip 13 to be shielded. Preferentially, the insulating material may be plastic. The insulating material may not only prevent the shielding can from touching the chip to be shielded, so that the shielding can does not interfere with the working of the chip to be shielded; in addition, the insulating material may also have an effect of supporting between the shielding can and the PCB, so that the chip packaging structure is more firm.

Further, the connecting the pins of the chip 13 to be shielded and the first pad 16 on the PCB 11 includes: welding the pins of the chip 13 to be shielded to one end of a conducting wire 17, and welding the other end of the conducting wire 17 to the first pad 16 on the PCB 11. This connection manner adopts a conventional chip bonding process, and the conducting wire may use a gold wire or an aluminum wire used in the conventional process. Definitely, the manner of connecting the pins of the chip to be shielded and the first pad is not limited to connecting through the conducting wire. Exemplarily, a corresponding location of the first pad may also be set according to locations of the pins of the chip to be shielded, and the pins of the chip to be shielded are welded on the first pad directly.

Further, if the chip packaging structure further needs to be packaged, the foregoing chip packaging structure further includes a packaging casing, where a third pad corresponding to the pins of the chip to be shielded is set on the packaging casing; and the third pad is connected to the first pad, so that the pins of the chip to be shielded corresponding to the third pad are led out. It should be noted that the packaging casing which is set with the third pad is not marked in a figure. However, those skilled in the art may understand the chip packaging structure described in the present invention according to the existing packaging process.

FIG. 2 is a vertical view of the chip packaging structure according to the embodiment of the present invention. A location relationship between each part of the chip packaging structure 100 provided in this embodiment of the present invention may be further clearly seen through FIG. 2. It should be noted that the metal plate and the insulating material between the metal plate and the PCB are not marked in FIG. 2. Referring to what is shown in FIG. 2, with reference to the foregoing description of the chip packaging structure, it may be clearly understood that the chip 13 to be shielded is located on the PCB 11; the conductor 121 is set around the PCB, and the pins of the chip 13 to be shielded are welded to one end of the conducting wire 17, and the other end of the conducting wire 17 is welded to the first pad 16 on the PCB 11.

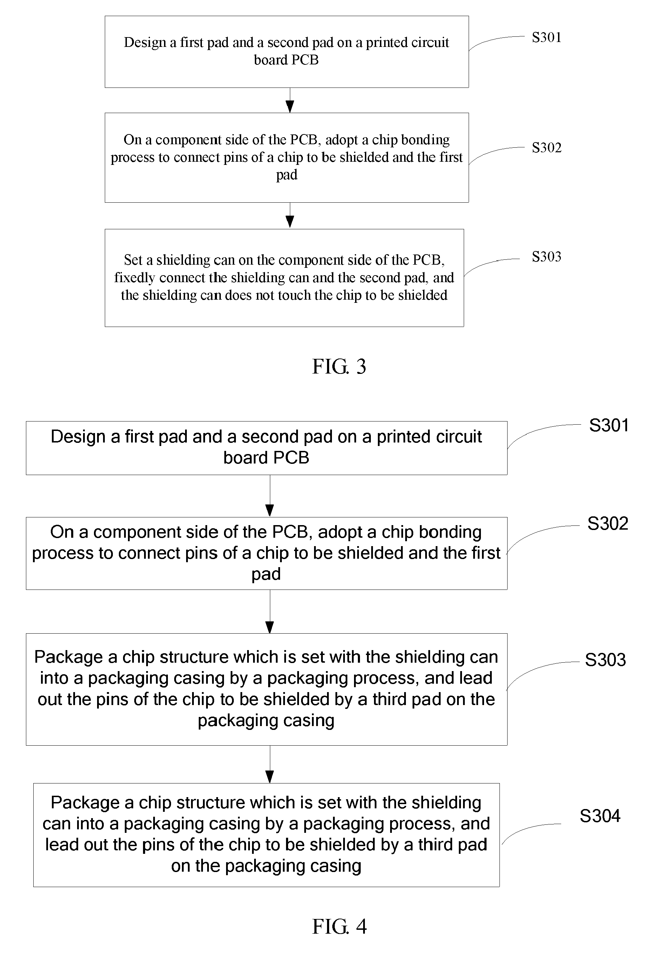

An embodiment of the present invention further provides a chip packaging method. As shown in FIG. 3 and with reference to FIG. 1, the packaging method specifically includes the following steps:
S301: Design a first pad 16 and a second pad 15 on a printed circuit board PCB 11.
S302: On a component side of the PCB 11, adopt a chip bonding process to connect pins of a chip 13 to be shielded and the first pad 16.
S303: Set a shielding can 12 on the component side of the PCB 11, fixedly connect the shielding can 12 and the second pad 15, and the shielding can 12 does not touch the chip 13 to be shielded.

In the chip packaging method provided in this embodiment of the present invention, the shielding can is fixedly set on the component side of the PCB, so that the chip to be shielded which is located in the shielding may not undergo interference from an external electromagnetic wave; in addition, because the shielding can is fixedly set on the PCB, the shielding can in this chip packaging structure does not drop off easily; meanwhile, the chip to be shielded does not touch the shielding can, so that the shielding can does not interfere with the working of the chip to be shielded.

Further, S303 may specifically include:
firstly, welding a conductor 121 onto the second pad 15 on the component side of the PCB 11;
and then, performing injection molding on the component side of the PCB 11, where a plastic plane is higher than the chip 13 to be shielded and lower than the conductor 121; and
finally, before the plastic is completely solidified, placing a metal plate on the conductor 121 of the PCB 11, and pressing to make the metal plate 122 closely stick to the plastic and have good contact with the conductor; after the plastic is solidified, the metal plate being bonded with the plastic.

In the foregoing injection molding process, the plastic is in a liquid state and is at a certain temperature, and the conductor is softened to some extent at the temperature; before the plastic is completely solidified, the metal plate is pressed on the conductor, so that the metal plate and the conductor have good contact. In addition, because the plastic is not completely solidified, press the metal plate to make it stick to the plastic, which may make the metal plate be bonded with the plastic after the plastic is solidified. In this way, it can be guaranteed that the metal plate does not drop off easily and also guaranteed the firmness of the finished chip packaging structure.

Further, if the chip packaging structure further needs to be packaged, as shown in FIG. 4, the method for making the chip packaging structure provided in the present invention may further include:
S304: Package the chip packaging structure which is set with the shielding can into a packaging casing through a packaging process, and lead out the pins of the chip to be shielded by a third pad on the packaging casing.

Specifically, a conducting wire may be used to connect the first pad and the third pad, so that the pins of the chip to be shielded are led out, and the packaging is completed.

For the packaging process, reference may be made to the packaging process in the prior art, for example, BGA (Its full name in English is Ball Grid Array, ball grid array) package, QFN (Quad Flat No-lead Package, quad flat no-lead package), and other packaging processes. The packaging process is understood by those skilled in the art, and is not further described here again.

It should be noted that the chip packaging method shown in FIG. 3 or FIG. 4 may be used as a reference and be applied in an actual making process of the chip packaging structure, but the sequence of the packaging method is not limited to the sequence shown in FIG. 3 or FIG. 4.

In addition, an embodiment of the present invention further provides an electronic device, including any one of the foregoing chip packaging structures. The electronic device may be a mobile terminal, and definitely may also be any electronic device which use a chip.

A mobile phone is taken as an example for detailed description in the following.

Mobile phone hardware mainly includes a display screen, an upper cover (front cover), a lower cover (back cover), a battery cover, a speaker, a microphone, and a main board, where the main board includes a radio frequency chip, a baseband chip, a power management chip, a Flash memory chip (flash memory chip). Pins of these chips on the main board are connected to peripheral devices of the mobile phone, such as an antenna, the display, the speaker, and the microphone, so as to implement basic functions of the mobile phone.

Any one or multiple (more than two) among the radio frequency chip, the baseband chip, the power management chip, and the Flash memory chip can adopt the chip packaging structure provided in embodiments of the present invention, so that the chips to be packaged in the mobile phone are not easily affected by the external electromagnetic wave, thereby having a strong anti-interference capability.

The foregoing descriptions are merely specific implementation manners of the present invention, but not intended to limit the protection scope of the present invention. Any variation or replacement that may be easily thought of by persons skilled in the art within the technical scope disclosed in the present invention should fall within the protection scope of the present invention. Therefore, the protection scope of the present invention should be subject to the protection scope of the claims.

## Claims

1. A chip packaging structure, comprising:
a printed circuit board PCB;
a shielding can, wherein the shielding can comprises a metal plate and a conductor that touches and supports the metal plate and the shielding can is fixedly set on a component side of the PCB, comprising welding the conductor of the shielding can onto a second pad on the component side of the PCB; and
a chip to be shielded, wherein the chip to be shielded is set on the component side of the PCB and is located inside the shielding can, and pins of the chip to be shielded are connected to a first pad on the PCB; and
the chip to be shielded does not touch the shielding can;
wherein,
the shape of pad including: circular, square, oval, rectangular, or octagonal; and,
the shape of the first pad is decided by the shapes of pins, the shape of the second pad is decided by the shape of the conductor.

2. The chip packaging structure according to claim 1, wherein the conductor is a metal wire or a solder ball.

3. The chip packaging structure according to claim 1, wherein the conductor is grounded.

4. The chip packaging structure according to any one of claims 1 to 3, wherein the pins of the chip to be shielded being connected to the first pad on the PCB comprises:
welding the pins of the chip to be shielded to one end of a conducting wire, and welding the other end of the conducting wire to the first pad on the PCB.

5. The chip packaging structure according to any one of claims 1 to 4, wherein the chip to be shielded not touching the shielding can comprises:
filling in insulating material between the shielding can and the PCB which is set with the chip to be shielded.

6. The chip packaging structure according to claim 5, wherein the insulating material are plastic.

7. The chip packaging structure according to any one of claims 1 to 6, further comprising a packaging casing, wherein a third pad corresponding to the pins of the chip to be shielded is set on the packaging casing; and
the third pad is connected to the first pad, so that the pins which is of the chip to be shielded and corresponds to the third pad are led out.

8. A chip packaging method, comprising:
designing a first pad and a second pad on a printed circuit board PCB;
on a component side of the PCB, adopting a chip bonding process to connect pins of a chip to be shielded and the first pad; and
setting a shielding can comprising a metal plate and a conductor that touches and supports the metal plate on the component side of the PCB, fixedly connecting the shielding can and the second pad, comprising welding the conductor of the shielding can onto the second pad on the component side of the PCB, wherein the shielding can is not touching the chip to be shielded;
wherein,
the shape of pad including: circular, square, oval, rectangular, or octagonal; and,
the shape of the first pad is decided by the shapes of the pins, the shape of the second pad is decided by the shape of the conductor.

9. The chip packaging method according to claim 8, wherein the setting the shielding can on the component side of the PCB, and fixedly connecting the shielding can and the second pad, and the shielding can not touching the chip to be shielded comprise:
welding a conductor onto the second pad on the component side of the PCB;
performing injection molding on the component side of the PCB, wherein a plastic plane is higher than the chip to be shielded and lower than the conductor; and
before the plastic is completely solidified, placing a metal plate on the conductor of the PCB, and pressing to make the metal plate closely stick to the plastic and have good contact with the conductor; after the plastic is solidified, the metal plate being bonded with the plastic.

10. The chip packaging method according to claim 8 or 9, further comprising:
packaging the chip which is set with the shielding can into a packaging casing by a packaging process, and leading out, by a third pad on the packaging casing, the pins of the chip to be shielded.

11. An electronic device, comprising the chip packaging structure according to any one of claims 1 to 7.
